# EUROPÄISCHE PATENTANMELDUNG

(11) **EP 1 990 331 A2**
(43) Veröffentlichungstag der Anmeldung: **12.11.2008**
(21) Anmeldenummer: 08075261.1
(22) Anmeldetag: 31.03.2008
(51) Int. Cl.: C04B 41/91, C03C 15/00, H01Q 1/38, H05K 1/03

(54) **Keramisches Substratmaterial, Verfahren zur Herstellung und Verwendung desselben sowie Antenne oder Antennenarray**

(30) Priorität: 04.05.2007 DE 102007020888
(71) Anmelder: Micro Systems Engineering GmbH, 95180 Berg (DE)
(72) Erfinder: Schwanke, Dieter, Dr., 95030 Hof (DE); Bittner, Achim, 96224 Burgkundstadt (DE); Schmid, Ulrich, Dr., 66125 Saarbrücken (DE); Harnack, Mirco, 95180 Berg (DE)
(74) Vertreter: Lindner-Vogt, Karin L.

(57) **Zusammenfassung**

Es wird ein Verfahren zur Herstellung eines keramischen Substratmaterials mit einer ersten Schicht und ggf. einer weiteren Schicht angegeben. Die erste Schicht einer ersten Schicht besteht aus mindestens einer ersten Komponente aus einem kristallinen Keramikmaterial und/oder einem Glasmaterial als Matrix und einer zweiten Komponente aus einem weiteren kristallinen Keramikmaterial, die in der Matrix vorliegt. Es wird ein Ätzschritt durchgeführt, wobei in der ersten Schicht selektiv Mantelbereiche der Kristalle und/oder Kristallagglomerate der zweiten Komponente geätzt werden, um eine Hohlraumstruktur in der ersten Schicht zu erzeugen. Die vorliegende Erfindung betrifft ferner ein entsprechendes keramisches Substratmaterial, eine Antenne oder ein Antennenarray sowie die Verwendung des keramischen Substratmaterials für eine Antenne oder ein Antennenarray.

## Beschreibung

Die Erfindung betrifft ein Verfahren zur Herstellung eines keramischen Substratmaterials mit einer ersten Schicht und ggf. einer weiteren Schicht, wobei die erste Schicht aus mindestens einer ersten Komponente aus einem kristallinen Keramikmaterial und/oder einem Glasmaterial als Matrix und einer zweiten Komponente aus einem kristallinen Keramikmaterial besteht, die in der Matrix vorliegt. Die Erfindung betrifft ferner ein keramisches Substratmaterial mit einer ersten Schicht und ggf. einer weiteren Schicht, wobei die erste Schicht aus mindestens einer ersten Komponente aus einem kristallinen Keramikmaterial und/oder einem Glasmaterial als Matrix besteht. Außerdem betrifft die vorliegende Erfindung die Verwendung eines derartigen keramischen Substratmaterials und eine Antenne bzw. ein Antennenarray.

Ein- oder mehrschichtige keramische Substratmaterialien bilden wichtige Ausgangsmaterialien für mikroelektronische Bauteile, insbesondere für die Telekommunikation. Eine Schicht stellt hierbei eine Lage oder ein Film des Substratmaterials mit einer großen Ausdehnung in zwei Raumrichtungen und einer vergleichsweise kleinen Ausdehnung in die dritte, zu den ersten beiden Raumrichtungen senkrecht verlaufenden Richtung des Raumes dar. Typischerweise hat eine gesinterte Schicht eines LTCC-Substrats eine Dicke von 140 µm.

Aus glaskeramischen Materialien werden sowohl Materialien mit niedriger Dielektrizitätskonstante als auch Materialen mit mäßig hoher Dielektrizitätskonstante (εᵣ) bzw. relativer Permittivität (auch als Dielektrizitätszahl oder Permittivitätszahl bezeichnet) gefertigt. Als Glaskeramik wird ein keramisches Material bezeichnet, das zunächst eine Glaszusammensetzung darstellt, die bei nachfolgendem Tempern bei Temperaturen bis zu 1000°C vor der Kristallisation zu einer dichten Masse sintert, so dass ein teilweise oder vollständig kristallines Material entsteht.

Eine wichtige und kostengünstige Technologie zur Herstellung von mikroelektronischen Substraten mit hoher Belegungsdichte ist die sogenannte "Low Temperatur Cofired Ceramics"-Technologie, im Folgenden als LTCC-Technologie bezeichnet. Die LTCC-Technologie ist eine Technologie zur Herstellung von Mehrlagenschaltungen auf der Basis von gesinterten Keramikträgern. Es können auf den Substraten Leiterbahnen, Kondensatoren, Widerstände und Spulen erzeugt werden. Diese Elemente werden durch Siebdruck oder fotochemische Prozesse auf die jeweilige ungebrannte Schicht aufgebracht. Die ungebrannten Keramikfolien werden einzeln strukturiert und anschließend gestapelt und laminiert. Danach wird zur Verfestigung der Struktur ein definiertes Sinterprofil mit einer Spitzentemperatur von ca. 850°C bis 900°C angewendet.

Ein- oder mehrlagige Substrate für elektronische Anordnungen werden häufig mit Materialien versehen, die eine niedrige Dielektrizitätskonstante aufweisen, wenn bei hohen Frequenzen eine hohe Geschwindigkeit der elektronischen Signale durch das Substrat erreicht werden soll. Bei einer niedrigen Dielektrizitätskonstante bzw. Permittivität wird erreicht, dass ein möglichst großer Teil des HF-Signals, bspw. einer Antenne, abgestrahlt wird und wenig Energie ins Material eingekoppelt und somit nutzmindernd verbraucht wird.

In der Druckschrift DE 100 43 194 A1 wird eine Glaskeramikmasse mit mindestens einer Oxidkeramik, die Barium, Titan und mindestens ein Seltenerdmetall aufweist, und mindestens einem Glasmaterial beschrieben, das mindestens ein Oxid mit Bor enthält. Das Glasmaterial weist außerdem ein Oxid mit mindestens einem vierwertigen Metall und ein Oxid mit mindestens einem Seltenerdmetall auf. Diese Glaskeramikmasse verdichtet bei einer Temperatur von unter 850°C und ist für den Einsatz in der Mikrowellentechnik geeignet. Insbesondere durch das Oxid des Seltenerdmetalls ist es möglich, die dielektrische Materialeigenschaften des Glasmaterials auf die dielektrischen Materialeigenschaften der Oxidkeramik abzustimmen. Dabei gilt, dass, je höher der Anteil von Lanthantrioxid am Glasmaterial ist, desto höher ist die Permittivität des Glasmaterials. Darüber hinaus ist die Zusammensetzung der Oxidkeramik und die des Glasmaterials so gewählt, dass während des Verdichtens (beispielsweise durch reaktives Flüssigphasensintern) und insbesondere nach dem Verdichten (bei höheren Temperaturen) Kristallisationsprodukte gebildet werden. Diese Kristallisationsprodukte beeinflussen nachhaltig die dielektrischen Materialeigenschaften der Glaskeramikmasse, so dass die Glaskeramikmasse in der Mikrowellentechnik eingesetzt werden kann. Auf diese Weise kann beispielsweise bei niedriger Verdichtungstemperatur eine Glaskeramikmasse mit relativ hoher Permittivität von über 15 und mit einer Güte von 350 erhalten werden. Das in DE 100 43 194 A1 beschriebene Material eignet sich jedoch nicht für Anwendungen bei hohen Frequenzen.

Aus der Druckschrift DE 42 34 349 C2 ist eine Verbundkeramik mit niedriger Dielektrizitätskonstante bekannt, in welcher eine Mehrzahl von Mullitblasen dispergiert sind, welche aus der Gruppe ausgewählt ist, die aus einer Glasmatrix auf Borsilikatbasis und einer Glaskeramikmatrix auf Aluminiumsilikatbasis besteht. Diese Mullitblasen werden typischerweise dadurch hergestellt, dass Aluminiumborsilikatblasen erwärmt werden. Die Mullitblasen haben typischerweise einen Durchmesser von bis zu etwa 50 µm. Die Herstellung dieser Materialien ist jedoch sehr aufwändig. Ferner ist mit einer nicht-planen Oberflächencharakteristik zu rechnen, die insbesondere den Einsatz von Dünnschichttechnik in diesem Bereich mit Strukturabmessungen im Mikrometer-Maßstab ausschließt.

In der Druckschrift US 5,108,958 wird eine keramische Materialzusammensetzung für elektronische Anwendungen beschrieben, die hohle, dünnwandige, feuerfeste Keramikblasen (ceramic bubbles) aufweist, die gleichmäßig in einer feuerfesten Keramikmatrix verteilt sind. Die Keramikblasen bestehen aus einem Material, das eine Dielektrizitätskonstante von weniger als 9 aufweist. Die bekannte Materialzusammensetzung hat eine niedrige dielektrische Konstante, einen niedrigen Verlustfaktor und einen thermischen Expansionskoeffizienten, der dem des IC-Chips angepasst werden kann. Die keramischen Blasen bestehen beispielsweise aus Aluminiumborsilikat, Mullit oder einer Mischung aus beiden. Die Durchmesser der Blasen betragen zwischen etwa 1 bis 50 µm und weisen eine Wanddicke von etwa 0,05 bis etwa 0,5 µm auf. Als Matrixmaterial werden Aluminiumoxid, Aluminiumphosphat, Mullit, Cordierit, Fosterit oder Steatit eingesetzt. Die Kristallite der in den Wänden der Blasen angeordneten Verbindungen bilden eine Netzwerkstruktur mit Hohlräumen in den Wänden der Blasen. Die Größe dieser Hohlräume beträgt etwa 0,5 µm. Die Herstellung und die Handhabung einer derartigen Materialzusammensetzung ist ebenfalls aufwändig. Zudem wird die Höhe der Dielektrizitätskonstante dadurch beeinflusst, ob die Keramikblasen während der Herstellung eines Bauteils brechen oder anderweitig zerstört werden.

In Druckschrift EP 0 234 896 A2 wird ein Material mit einer niedrigen Dielektrizitätskonstante offenbart, das sich für Schaltkreise der Dickfilmtechnik wie VLSI-Elemente eignet. Aus der Druckschrift geht hervor, dass die dielektrische Konstante eines isolierenden Materials mit einer Schicht aus hohlen Glasmikrokugeln durch das große Luftvolumen in den Kugeln bereits bei einem kleinen Anteil der Kugeln, d. h. oberhalb eines Anteils von 10 bis 15 Volumen% in der Schicht zu einer signifikanten Reduktion der dielektrischen Konstante führt. Oberhalb eines Anteil von 45 bis 50 Volumen% der Glasmikrokugeln in der Schicht wird jedoch die strukturelle Festigkeit und der thermische Widerstand der resultierenden isolierenden Schichten negativ beeinflusst.

Ebenfalls die Einbettung von hohlen Mikrokugeln in eine dielektrische Zusammensetzung wird in Druckschrift US 4,867,935 offenbart. Hierbei handelt es sich um hohle Mikrokugeln aus einer Keramik, die in eine keramische Matrix eingebettet ist. Diese Druckschrift offenbart auch die Nachteile der Verwendung von hohlen Mikrokugeln. Diese können während des Herstellungsverfahrens brechen, so dass die gewünschte Erniedrigung der dielektrischen Konstante nicht erreicht wird. In der Druckschrift US 4,867,935 wird dieses Problem dadurch behoben, dass die hohlen keramischen Mikrokugeln bei hohen Geschwindigkeiten in einer gemahlenen Mixtur dispergiert werden, so dass ein Schlicker mit einer Viskosität im Bereich von etwa 500 bis 1500 cps entsteht. Dies ist jedoch ein recht aufwändiges Herstellungsverfahren.

Als weitere Nachteile einer Schicht mit Mikrokugeln offenbart die Druckschrift US 4,867,935 außerdem, dass sich bei einem zu hohen Anteil (über 40%) der Mikrokugeln die Luftdichtigkeit des resultierenden keramischen Produkts verschlechtert. Zudem kann die Oberflächenrauhigkeit der Schicht problematisch bei der Weiterverarbeitung der Schicht werden. Demgegenüber kann bei einem zu niedrigen Anteil der Mikrokugeln die gewünschte Erniedrigung der dielektrischen Konstante nicht erreicht werden.

Aus der Druckschrift DE 100 42 653 A1 ist eine keramische Mehrlagenschaltung aus mindestens zwei aufeinander liegenden keramischen Schichten bekannt, die sich in ihrer Dielektrizitätskonstante unterscheiden. Zur Herstellung einer derartigen keramischen Mehrlagenschaltung mittels des LTCC-Verfahrens wird vorgeschlagen, grüne Keramikfolien zur Stapelung und anschließender Sinterung im gestapelten Zustand übereinander anzuordnen, die das gleiche Rohmaterial wie die übrigen Schichten jedoch im Vergleich zu diesen eine abgesenkte Kristallisationstemperatur aufweisen. Hierdurch kristallisieren diese Schichten frühzeitig und frieren somit eine hohe Porosität ein. Die Bereiche mit einer hohen Porosität weisen eine verringerte Dielektrizitätskonstante auf. Die abgesenkte Kristallisationstemperatur kann dadurch erreicht werden, dass das keramische Rohmaterial vor dem Gießen und Trocknen vergleichsweise fein gemahlen wird oder dem Material Kristallisationskeime hinzugefügt werden. Das geschilderte Verfahren hat den Nachteil, dass das LTCC-Verfahren verändert werden muss und zusätzliche Schichten verwendet werden, die unter Umständen ein anderes Schwindungsverhalten wie die übrigen Schichten aufweisen.

In dem Dokument GB 2 266 181 A wird ein integrierter Halbleiterschaltkreis mit einer Zwischenschicht aus isolierendem Material beschrieben, welche die Kapazität der Schaltkreise reduziert und die Betriebsgeschwindigkeit erhöht. Die isolierende Zwischenschicht weist eine Glasmatrix auf, die Aluminium- oder Tantalpartikel enthält. Diese können durch ein Ätzmittel wie NaOH oder KOH weggeätzt werden, so dass eine Schicht entsteht, in der Hohlräume gleichmäßig verteilt angeordnet sind. Der Nachteil dieses Verfahrens ist, dass es sich lediglich für sehr dünne Schichten mit einer Dicke von weniger als 1 µm eignet. Derartige dünne Schichten werden in Halbleiterschaltkreisen eingesetzt, für die Anwendung für Antennen sind sie nicht geeignet. Durch die fehlende Verbindung der Partikel untereinander ist das Ätzen einer dickeren Schicht nicht möglich.

Es ist daher Aufgabe der vorliegenden Erfindung, ein einfaches und kostengünstiges sowie sicheres Verfahren zur Herstellung eines keramischen Substratmaterials für Dickschichtanwendungen im Bereich von Schichtdicken oberhalb von mehreren 10 µm, vorzugsweise mit Schichtdicken von etwa 20 bis etwa 30 µm, anzugeben, das ein Substratmaterial mit einer niedrigen Dielektrizitätskonstante erzeugt. Die Aufgabe besteht ferner darin, ein entsprechendes dickes keramisches Substratmaterial zu schaffen, das den Einsatz der LTCC-Technologie ermöglicht. Die Aufgabe besteht zudem darin, eine geeignete Verwendung eines derartigen keramischen Substratmaterials anzugeben. Außerdem besteht die Aufgabe darin, eine Antenne oder ein Antennenarray mit einem dicken Substratmaterial anzugeben, die einfach und kostengünstig herstellbar sind.

Die angegebene Aufgabe wird durch ein Verfahren zur Herstellung eines keramischen Substratmaterials gelöst, bei dem ein Ätzschritt derart durchgeführt wird, dass in der ersten Schicht selektiv Mantelbereiche der Kristalle und/oder Kristallagglomerate der zweiten Komponente geätzt werden, um eine Hohlraumstruktur in der ersten Schicht zu erzeugen. Vorzugsweise ist die Hohlraumstruktur eine Poren- oder Röhrenstruktur. Die Struktur der Hohlräume richtet sich nach der Struktur bzw. Raumform, in der die Mantelbereiche der zweiten Komponente vorliegen, die vorzugsweise aus einer oder mehreren Übergangs- oder Zwischenphasen gebildet werden. Die Übergangs- und Zwischenphasen weisen bevorzugt gegenüber der Struktur und/oder Zusammensetzung der kristallinen zweiten Komponente eine geringfügig veränderte Kristallstruktur, die auch bereichsweise amorph sein kann, und/oder eine geringfügig veränderte Zusammensetzung auf. In der Zusammensetzung können die Mantelbereiche auch Bestandteile der Matrix aufweisen. Die Zusammensetzung und/oder die Struktur der Mantelbereiche können dabei über einen bestimmten Bereich variieren. Der Mantelbereich eines Kristalls oder Kristallagglomerats, das aus mehreren Kristallen zusammengesetzt ist, umfasst somit den Korngrenzbereich des jeweiligen Kristalls oder Kristallagglomerats, kann sich aber auch darüber hinaus in den Kristall mit der stöchiometrischen Zusammensetzung der zweiten Komponente hinein erstrecken. Die Ausdehnung des Mantelbereichs hängt dabei auch von der Ätzdauer und dem verwendeten Ätzmittel ab.

Das angegebene Verfahren ist ein sehr einfaches und kostengünstiges sowie gut beherrschbares Verfahren, um ein keramisches Substratmaterial mit einer niedrigen dielektrischen Konstante zu erzeugen. Es bringt ferner nicht die oben angegebenen Nachteile bei der Verwendung von hohlen Mikrokugeln mit und lässt das LTCC-Verfahren unverändert. Zudem lassen sich durch die selektive Ätzung der Mantelbereiche Schichten mit einer größeren Dicke im Bereich von mehreren 10 µm, vorzugsweise Schichtdicken zwischen etwa 20 µm und etwa 30 µm ätzen, da die Mantelbereiche der Kristalle und/oder Kristallagglomerate die nebeneinander liegenden Kristalle und Kristallagglomerate miteinander verbinden und so das Ätzmittel während des Ätzens entlang der Mantelbereiche in die Schicht vordringt.

Der Porosiziervorgang, d. h. der Ätzschritt, in dem die Hohlraumstruktur in der Matrix des Schichtkörpers erzeugt wird, ermöglicht, eine Dielektrizitätskonstante zu erzeugen, die zwischen Luft (ca. 1) und der verbleibenden Glaskeramik bzw. kristallinen Keramik liegt. Hierbei können in den porosizierten Bereichen resultierende Dielektrizitätskonstanten εᵣ, die sich aus der Dielektrizitätskonstante des nach dem Ätzvorgang verbleibenden Materials der geätzten Schicht und der Dielektrizitätskonstante der Hohlraumstruktur zusammensetzt, von bis zu 2 erreicht werden.

Die vorliegende Erfindung nutzt die Erkenntnis, dass das eine Material, d. h. das Material mit einer höheren Dielektrizitätskonstante, bei mehrphasigen Materialen mit nicht nur zwei strukturell und von ihrer Zusammensetzung völlig verschiedenen Materialien, sondern mit Materialien, die von ihrer Zusammensetzung und Struktur näher beieinander liegen (zweite Komponente einerseits sowie die Mantelbereiche der Kristalle und Kristallagglomerate der zweiten Komponente andererseits), die sich durch ihr Ätzverhalten unterscheiden, herausgeätzt werden kann. In den herausgeätzten Bereichen liegt nach dem Ätzschritt Luft mit einer Dielektrizitätskonstante von ca. 1 vor. Die beiden Materialien müssen hierfür selektiv ätzbar sein.

In einem bevorzugten Ausführungsbeispiel wird der Ätzschritt, vorzugsweise mittels einer entsprechenden Maske, in einem vorbestimmten Bereich der ersten Schicht und/oder bis zu einer vorbestimmten Tiefe der ersten Schicht durchgeführt, um lediglich in dem vorbestimmten Bereich und/oder bis zu der vorbestimmten Tiefe der ersten Schicht eine Hohlraumstruktur in der ersten Schicht zu erzeugen. Hierdurch wird erreicht, dass eine lokal reduzierte Dielektrizitätskonstante, nämlich im Bereich der Öffnung der Ätzmaske bis in eine vorgegebene Tiefe der ersten Schicht, bzw. ein lokal reduzierter Verlustfaktor oder eine lokale Reduzierung der thermischen Leitfähigkeit vorliegt. Ferner können definiert mechanische Sollbruchstellen eingebracht werden. Hierbei wird die Ätztiefe hauptsächlich durch die Prozessparameter Temperatur, Konzentration des Ätzmediums und die Zeit der Einwirkung des Ätzmediums gesteuert. Beispielsweise kann bei einer Prozesszeit von 6 Stunden durch ein phosphorsäurebasiertes Ätzmittel eine Tiefe der Hohlraumstruktur in der ersten Schicht von 20 µm erreicht werden.

In einem weiteren bevorzugten Ausführungsbeispiel bilden die Matrix und die zweite Komponente vor dem Ätzschritt ein Glaskeramik-Material. Dieses Material lässt sich gut im Hinblick auf die erforderliche Kristallgröße und -verteilung der zweiten Komponente sowie des Mantelbereichs der Kristalle und Kristallagglomerate in der ersten Schicht und damit die spätere Struktur der eingeätzten Hohlraumstruktur steuern. Das Glaskeramik-Material lässt sich sehr einfach mittels der LTCC-Technologie verarbeiten. Zudem sind die entsprechenden Bänder (Tapes) kommerziell erhältlich.

In einem weiteren Ausführungsbeispiel enthält die zweite Komponente Al₂O₃-Kristallite und/oder eine von Al₂O₃ verschiedene aluminiumbasierte kristalline Verbindung und/oder eine aluminiumoxidbasierte kristalline Verbindung sowie umgebende Mantelbereiche, die als Grenzübergangsschicht Kristalle und/oder Kristallagglomerate der zweiten Komponente enthält, also unter anderem Al₂O₃-Kristallite und/oder eine von Al₂O₃ verschiedene aluminiumbasierte kristalline Verbindung und/oder eine aluminiumoxidbasierte kristalline Verbindung bestehen. Die Mantelbereiche der angegebenen Bestandteile der zweiten Komponente bzw. die angegebenen Mantelbereiche lassen sich besonders einfach mittels des bevorzugten nasschemischen Ätzverfahrens, vorzugsweise mittels eines phosphorsäurebasierten Ätzmittels ätzen. Das phosphorsäurebasierte Ätzmittel wird auch für andere Ätzschritte, in denen andere Strukturen hergestellt werden, genutzt, sodass die Handhabung dieses Ätzmittels in der Produktion bekannt ist.

In einem besonders bevorzugten Ausführungsbeispiel weist das Substratmaterial mindestens zwei Schichten auf, wobei die mindestens zwei Schichten zunächst als LTCC mittels der LTCC-Technologie hergestellt werden und anschließend in der ersten Schicht eine Hohlraumstruktur erzeugt wird. Die Herstellung der beiden LTCC-Schichten beinhaltet dabei, wie eingangs beschrieben, mindestens einen Sinterschritt, so dass das Porosizieren in der gesinterten ersten Schicht erfolgt. Bei diesem Ausführungsbeispiel ist von Vorteil, dass das Substrat zunächst mit der in der keramischen Mehrlagentechnik üblichen Prozessführung mit innen liegenden Komponenten und Vias hergestellt werden kann, die durch den Ätzvorgang nicht beeinträchtigt werden. Damit ist der Bereich der Dielektrizitätskonstante zwischen 3 und 4, der bisher mittels organischer HF-Materialien realisiert wurde, auch für Keramiken erschlossen, die mittels LTCC-Technologie hergestellt werden.

Weiterhin ist es möglich, mit herkömmlichen Methoden der Dünn- und Dickschichttechnik Funktionsschichten auf das porosizierte Material sowie ohne Unterbrechung über den Übergang zwischen porosiziertem und nicht porosiziertem Material aufzubringen.

Die obige Aufgabe wird außerdem durch ein keramisches Substratmaterial gelöst, bei dem die erste Schicht eine zweite Komponente aus einem weiteren kristallinen Keramikmaterial enthält, wobei die Mantelbereiche der Kristalle und/oder Kristallagglomerate der zweiten Komponente mindestens bereichsweise derart herausgeätzt sind, dass eine Hohlraumstruktur vorliegt. Dieses keramische Substratmaterial ist einfach und kostengünstig herzustellen. Zudem weist das Substratmaterial, wobei Schichtdicke der ersten Schicht vorzugsweise mehrere 10 µm beträgt, bereichsweise die gewünschte niedrige resultierende Dielektrizitätskonstante von bis zu 2 auf.

Besonders bevorzugt ist die Hohlraumstruktur, die eine Poren- oder Röhrenstruktur ist. Diese lässt sich einfach herstellen.

Die zweite Komponente enthält bevorzugt Al₂O₃-Kristallite und/oder eine von Al₂O₃ verschiedene aluminiumbasierte kristalline Verbindung und/oder eine aluminiumoxidbasierte kristalline Verbindung, vorzugsweise mit einem Gesamtanteil von höchstens 40 Volumen% der ersten Schicht, und in den Mantelbereichen. Durch diesen Anteil der zweiten Komponente bzw. den entsprechenden Anteil der Mantelbereiche der Kristalle und/oder Kristallagglomerate der zweiten Komponente wird in den geätzten Bereichen der ersten Schicht eine ausreichende Festigkeit des keramischen Substratmaterials nach dem Ätzen und zugleich eine niedrige Dielektrizitätskonstante erreicht. Die aluminium- und aluminiumoxidbasierten Verbindungen, die die Mantelbereiche der zweiten Komponente enthalten, lassen sich zudem mit einem phosphorsäurebasierten Ätzmittel einfach ätzen.

Besonders bevorzugt liegt die geätzte Hohlraumstruktur lediglich in einem vorbestimmten Bereich der ersten Schicht vor und reicht bis in eine vorbestimmte Tiefe der ersten Schicht. Dieses führt zu einer vorteilhaften lokalen Erniedrigung der Dielektrizitätskonstante, des Verlustfaktors bzw. zu einer lokalen Reduzierung der thermischen Wärmeleitfähigkeit.

In den geätzten Bereichen beträgt die resultierende Dielektrizitätskonstante εᵣ, vorzugsweise zwischen etwa 10 und 1, besonders bevorzugt zwischen etwa 5 und 1. Die lokale Reduktion von εᵣ ist vorteilhaft, da für einen Radarsensor, insbesondere im Bereich von 80 GHz, das Verteilnetzwerk eine hohe Dielektrizitätskonstante aufweisen soll, um Abstrahlungeffekte zu minimieren.

Besonders bevorzugt weist das keramische Substratmaterial mindestens zwei Schichten auf, die mittels LTCC-Technologie hergestellt sind. Die LTCC-Technologie vereinfacht die Herstellung des keramischen Substratmaterials weiter. Das Verfahren ist zudem kostengünstig.

Die erfindungsgemäße Verwendung eines oben angegebenen keramischen Substratmaterials umfasst die Anwendung für eine Antenne oder ein Antennenarray, insbesondere für hohe Frequenzen im Bereich von 80 GHz.

Erfindungsgemäß wird die Aufgabe auch durch eine Antenne oder ein Antennenarray mit einem oben angegebenen erfindungsgemäßen Substratmaterial gelöst.

Bei den herkömmlichen Antennen oder Antennenarrays wird typischerweise ein Rogers-Tape in eine LTCC-Kavität geklebt und die darüber liegende Metallisierung der beiden Bereiche mittels Drahtbonding verbunden. In einem bevorzugten Ausführungsbeispiel weist eine erfindungsgemäße Antenne oder ein erfindungsgemäßes Antennenarray demgegenüber in jedem seiner Elemente in der ersten Schicht bereichsweise eine geätzte Hohlraumstruktur auf und die darüber liegende Metallisierung erstreckt sich von dem Bereich mit der geätzten Hohlraumstruktur bis in einen Bereich, in dem keine geätzte Hohlraumstruktur vorliegt. Die Metallisierung kann hierbei als Dickschicht- oder Dünnfilmmetallisierung ausgeführt sein. Der Vorteil einer derartigen Antenne oder eines derartigen Antennenarrays besteht darin, dass eine Drahtbond-Verbindung zwischen den Metallisierungen nicht mehr notwendig ist und hierdurch die Zuverlässigkeit des Gesamtaufbaus erhöht wird, da eine Kombination von Materialien entfällt und die Anzahl der Bond-Klebestellen reduziert wird. Zudem wird die AVT (Aufbau- und Verbindungstechnik) vereinfacht, da kein Bondschritt notwendig ist.

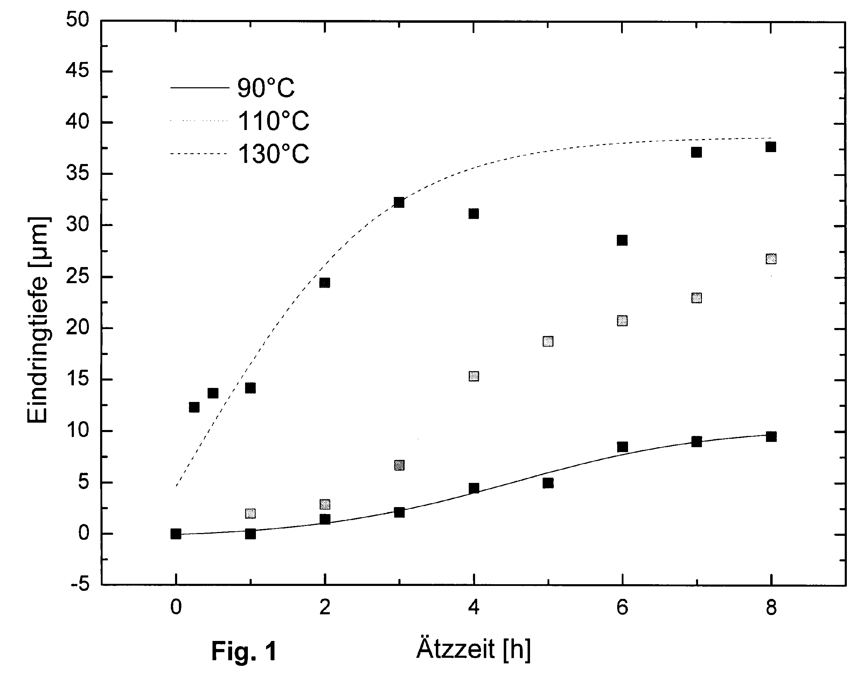

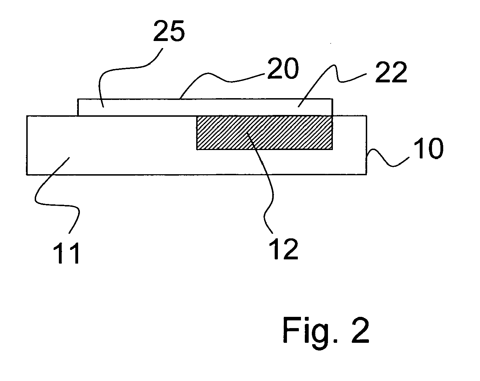

Weitere Ziele, Merkmale, Vorteile und Anwendungsmöglichkeiten der Erfindung ergeben sich aus der nachfolgenden Beschreibung eines Ausführungsbeispiels anhand eines in Figur 1 angegebenen Diagramms. Ferner wird der Aufbau einer erfindungsgemäßen Antenne anhand einer schematischen Schnittzeichnung in Figur 2 dargestellt. Alle beschriebenen und/oder bildlich dargestellten Merkmale bilden für sich oder in beliebiger Kombination den Gegenstand der vorliegenden Erfindung, unabhängig von ihrer Zusammenfassung in den einzelnen Ansprüchen oder deren Rückbeziehung

### Beispiele

Ein Substratmaterial mit einer ersten Schicht aus einer gesinterten Glaskeramik, z. B. ein LTCC-Tape mit der Zusammensetzung 30% SiO₂, 40% Al₂O₃, 4% CaO, 9% PbO, 2% B₂O₃ + Rest - bekannt unter der Produktbezeichung DP951, der Zusammensetzung 30% SiO₂, 20% Al₂O₃, 3% CaO, 5% SrO, 17% BaO, 5% ZnO + Rest - bekannt als "Heraeus-Tape" - oder der Zusammensetzung ca. 50% Al₂O₃, ca. 15% B₂O₃, ca. 15% La₂O₃, + Rest, welche unter der Produktbezeichnung DP943 der Fa. Hereaus bekannt ist, wird zum Porosizieren bei einer Temperatur von 110°C in eine geeignete Ätzlösung (z.B. für DP951, "Heraeus-Tape" und DP943 Phosphorsäure) gelegt. Der Porosiziervorgang kann alternativ auch mit KOH (Kalilauge) einer Konzentration von etwa 40% bei einer Temperatur im Bereich von 80°C durchgeführt werden.

Die in dem Diagramm der Figur 1 dargestellte Kurve zeigt die Abhängigkeit der Eindringtiefe der Ätzlösung Phosphorsäure in das Volumen der Glaskeramik DP951, welches eine Zusammensetzung von 30% SiO₂, 40% Al₂O₃, 4% CaO, 9% PbO, 2% B₂O₃ + Rest aufweist bei einer Ätztemperatur von 110°C bzw. 90°C und damit die Tiefe der in der ersten Schicht erzeugten Hohlraumstruktur in µm auf der Y-Achse von der auf der X-Achse aufgetragenen Ätzzeit in Stunden, da die Eindringtiefe durch die Ätzzeit gesteuert werden kann. Beispielsweise wird bei einer Ätztemperatur von 110°C eine Eindringtiefe von 15 µm bei einer Ätzzeit von vier Stunden erreicht.

In Figur 2 ist der Aufbau einer erfindungsgemäßen Antenne im Schnitt dargestellt. In einer ersten Schicht 10 ist ein porosizierter Bereich 12 mit der geätzten Hohlraumstruktur vorgesehen, der eine niedrige Dielektrizitätskonstante aufweist. Der porosizierte Bereich 12 geht nahtlos in die übrigen, nicht porosizierten Bereiche 11 der ersten Schicht 10 über. Auf der Oberfläche ist eine metallisierte Schicht (Metallisierung) 20 angeordnet, die oberhalb des porosizierten Bereichs 12 als Antennenstruktur 22 ausgebildet ist. Oberhalb der übrigen Bereiche 11 der ersten Schicht 10 ist die metallisierte Schicht als Leiterbahn 25 ausgebildet. Die Metallisierung mit der Antennenstruktur 22 und der Leiterbahn 25 kann gleichzeitig in einem Metallisierungsschritt ohne zusätzliche Bondverbindung aufgebracht werden.

## Patentansprüche

1. Verfahren zur Herstellung eines keramischen Substratmaterials mit einer ersten und ggf. einer weiteren Schicht, wobei die erste Schicht aus mindestens einer ersten Komponente aus einem kristallinen Keramikmaterial und/oder einem Glasmaterial als Matrix und einer zweiten Komponente aus einem weiteren kristallinen Keramikmaterial besteht, die in der Matrix vorliegt, **dadurch gekennzeichnet, dass** ein Ätzschritt derart durchgeführt wird, dass in der ersten Schicht selektiv Mantelbereiche der Kristalle und/oder Kristallagglomerate der zweiten Komponente geätzt werden, um eine Hohlraumstruktur in der ersten Schicht zu erzeugen.

2. Verfahren nach Anspruch 1, **dadurch gekennzeichnet, dass** in dem Mantelbereich der Kristalle und/oder Kristallagglomerate der zweiten Komponente eine Übergangs- oder Zwischenphase der zweiten Komponente geätzt wird.

3. Verfahren nach einem der Ansprüche 1 oder 2, **dadurch gekennzeichnet, dass** die Hohlraumstruktur eine Poren- oder Röhrenstruktur ist.

4. Verfahren nach einem der Ansprüche 1 bis 3, **dadurch gekennzeichnet, dass** der Ätzschritt, vorzugsweise mittels einer entsprechenden Maske, in einem vorbestimmten Bereich der ersten Schicht und/oder bis zu einer vorbestimmten Tiefe der ersten Schicht erfolgt, um lediglich in dem vorbestimmten Bereich und/oder bis zu der vorbestimmten Tiefe der ersten Schicht eine Hohlraumstruktur in der ersten Schicht zu erzeugen.

5. Verfahren zur Herstellung nach einem der vorhergehenden Ansprüche, **dadurch gekennzeichnet, dass** die Matrix und die zweite Komponente vor dem Ätzschritt ein Glaskeramik-Material bilden.

6. Verfahren zur Herstellung nach einem der vorhergehenden Ansprüche, **dadurch gekennzeichnet, dass** die zweite Komponente Al₂O₃-Kristallite und/oder eine von Al₂O₃ verschiedene aluminiumbasierte kristalline Verbindung und/oder eine aluminiumoxidbasierte kristalline Verbindung und in den Mantelbereichen Kristalle und/oder Kristallagglomerate der zweiten Komponente enthält.

7. Verfahren zur Herstellung nach einem der vorhergehenden Ansprüche, **dadurch gekennzeichnet, dass** der Ätzschritt einen nasschemischen Ätzschritt, vorzugsweise mittels eines phosphorsäurebasierten Ätzmittels, beinhaltet.

8. Verfahren zur Herstellung nach einem der vorhergehenden Ansprüche **dadurch gekennzeichnet, dass** das Substratmaterial mindestens zwei Schichten aufweist und dass die mindestens zwei Schichten zunächst als LTCC (Low Temperature Cofired Ceramics) hergestellt werden und anschließend in der ersten Schicht eine Hohlraumstruktur erzeugt wird.

9. Keramisches Substratmaterial mit einer ersten Schicht und ggf. einer weiteren Schicht, wobei die erste Schicht aus mindestens einer ersten Komponente aus einem kristallinen Keramikmaterial und/oder einem Glasmaterial als Matrix besteht, **dadurch gekennzeichnet, dass** die erste Schicht eine zweite Komponente aus einem weiteren kristallinen Keramikmaterial enthält, wobei Mantelbereiche der Kristalle und/oder Kristallagglomerate der zweiten Komponente mindestens bereichsweise derart herausgeätzt sind, dass eine Hohlraumstruktur vorliegt.

10. Keramisches Substratmaterial nach Anspruch 9, **dadurch gekennzeichnet, dass** der Bereich der ersten Schicht, in der die geätzte Hohlraumstruktur vorliegt, eine resultierende Dielektrizitätskonstante εᵣ zwischen etwa 10 und 1, vorzugsweise zwischen etwa 5 und 1 aufweist.

11. Antenne oder Antennenarray mit einem keramischen Substratmaterial nach Anspruch 9 oder 10.

12. Antenne oder Antennenarray nach Anspruch 11, **dadurch gekennzeichnet, dass** die ersten Schicht (10) bereichsweise eine geätzte Hohlraumstruktur (12) aufweist und eine darüber liegende Metallisierung (20) sich von dem Bereich mit der geätzten Hohlraumstruktur bis in einen Bereich erstreckt, in dem keine geätzte Hohlraumstruktur vorliegt.
